# EUROPEAN PATENT SPECIFICATION

(11) **EP 2 180 611 B1**
(45) Date of publication and mention of the grant of the patent: **01.05.2013**
(21) Application number: 08305715.8
(22) Date of filing: 23.10.2008
(51) Int. Cl.: H04B 10/2575, H03F 3/21, H03F 3/24

(54) **A method for transmission of data signals using a switched mode power amplifier, a switched mode power amplifier and a communication network therefor**
Verfahren zur Datensignalübertragung mit Schaltmodus-Leistungsverstärker, Schaltmodus-Leistungsverstärker und Kommunikationsnetzwerk dafür
Procédé de transmission de signaux de données utilisant un amplificateur de puissance en mode commuté, amplificateur de puissance en mode commuté et réseau de communication correspondant

(43) Date of publication of application: 28.04.2010
(73) Proprietor: Alcatel Lucent, 75007 Paris (FR)
(72) Inventor: Pascht, Andreas, 73614, Schorndorf (DE); Templ, Wolfgang, 74372, Sersheim (DE)
(74) Representative: Kleinbub, Oliver

(56) References cited:
- EP-A- 1 553 791
- WO-A-01/65732
- CA-A1- 2 362 104
- US-A1- 2004 239 416

## Description

The invention relates to a method for transmission of data signals according to the preamble of claim 1, a switched mode power amplifier according to the preamble of claim 7, a transmitting device according to the preamble of claim 9, a receiving device according to the preamble of claim 12, and a communication network according to the preamble of claim 15.

The coverage of a certain service area in a cellular radio network is provided by several radio base stations, which are connected to a core network to serve connections to and from mobile users within the service area. A radio base station contains a baseband unit and at least one antenna unit. In order to increase radio coverage and capacity, modern base stations use several sector antennas.

In order to increase flexibility of the base stations, it is desirable to allow the antennas to be located remote from the baseband unit. This has lead to the development of active antenna systems which are also termed remote antenna heads. Typically, one remote antenna head contains one sector antenna, but there are also systems known, which have remote antenna heads with more than only one sector antenna.

The base stations are preferably connected with the remote antenna heads by means of optical fibers. Conventional radio-over-fiber scenarios involve optical transmission of analogue signals between a base station and a transmitter with an amplifier in a remote antenna head.

An example for the implementation of a radio-over-fiber concept in a cellular radio network using a two-fiber-ring is given in the European patent EP 1553791 B1.

However, the quality of the optical transmission suffers severely from noise, non-linearities, like e.g. chromatic dispersion, and attenuation effects. Consequently the technical implementations for radio-over-fiber concepts must involve highly sophisticated optical modulation techniques and signal conditioning.

In the Canadian patent application CA-A1-2 362 104, a method is disclosed for transmission of data signals over an optical connection from a transmitting device to a receiving device using a switched mode power amplifier, wherein modulated data signals are converted from electrical data signals into optical data signals in the transmitting device, and the modulated data signals are converted from optical data signals into electrical data signals and amplified in the receiving device.

Basically, the optical transmission of analogue radio frequency signals involves high electronic efforts for signal modulation techniques and signal conditioning. Indeed, e.g. the method of intensity modulation and direct detection is straightforward, simple and allows for fairly linear optical transmission properties, but on the other hand it requires costly modulators and modulator drivers in order to meet the requirements for analogue radio frequency transmission. In case double side band modulation is used, chromatic dispersion will result in frequency and length dependent suppression of radio frequency power, which will deteriorate the transmission quality.

Furthermore, the application of conventional base station architectures in this context involves additional high effort to align the up-conversion module with requirements for power amplifier predistortion and linearization. Additionally like all class S radio frequency power amplifier concepts it involves the need for intricate high speed delta/sigma conversion of the radio frequency signal.

Electronic up-conversion of the wanted baseband signal to the radio frequency domain involves high effort when linearising the radio frequency power amplifier and entails complex and power intense signal processing. In existing class S radio frequency power amplifier concepts, the modulated radio frequency signal is converted by means of a fast delta/sigma converter to a bit stream. The resulting bitstream controls the radio frequency power transistors.

The object of the invention is thus to propose a cost-effective and fault-tolerant method for transmission of signals from a transmitting device to at least one receiving device that avoids the need for electronic up-conversion using a power amplifier for signal amplification with an optical connection between the transmitting device and the at least one receiving device.

This object is achieved by a method according to the teaching of claim 1, a switched mode power amplifier according to the teaching of claim 7, a transmitting device according to the teaching of claim 9, a receiving device according to the teaching of claim 12, and a communication network according to the teaching of claim 15.

As mobile communication systems like e.g. Universal Mobile Telecommunications System (UMTS), Worldwide Interoperability for Microwave Access (WIMAX), or Third Generation Partnership Project Long Term Evolution (3GPP LTE) require power amplifiers with high output power at frequencies up to 2.6 GHz, preferably so-called class S power amplifiers, which comprise so-called class D/E/F output stages, are used for signal amplification. In said class S power amplifiers, the transistor is not amplifying the input signal linearly, but is acting as a switch in the ideal case. As an ideal switch does not dissipate power, a power efficiency of 100% is theoretically reachable.

The main idea of the invention is to exploit the existence of a digital signal path inside the existing switched mode power amplifier concept for optical transmission of radio frequency signals by dividing the switched mode power amplifier into two remote parts connected by an optical fiber link, as digital signals are more fault-tolerant against interferences than analogue signals. Additionally, the invention applies the concept of optical heterodyning in order to mix baseband signals and radio frequency carrier signals which control distributed class S radio frequency power amplifier, thus avoiding the need for electronic up-conversion.

The invention enables transmission of digital instead of analogue signals by drawing use from a digital signal path which is already existing inside switched mode power amplifiers. As a digital signal which is already available within the switched mode power amplifiers is used, there is no need for additional costly high speed analogue-to-digital and digital-to-analogue conversion. Thus, compared with conventional radio-over-fiber scenarios, at zero additional costs all the concepts for optical transmission of digital signals can be applied to radio-over-fiber applications.

For transmission of signals from a base station via at least one remote antenna head to a user terminal, a switched mode power amplifier for signal amplification is used, and the signals are transmitted over at least one optical connection from the base station to the at least one remote antenna head.

According to the invention data signals are modulated on a baseband frequency or on at least one intermediate frequency in a first part of the switched mode power amplifier before being passed to a delta sigma modulator that is located in the base station, the data signals are converted from electrical signals into optical signals in an electro-optical converter in the first part of the switched mode power amplifier, radio frequency carrier signals are converted from electrical signals into optical radio frequency carrier signals in a further electro-optical converter in the first part of the switched mode power amplifier, the optical data signals are added to the optical radio frequency carrier signals resulting in combined optical data signals, the combined optical data signals are converted from optical data signals into up-converted electrical data signals in an opto-electrical converter applying optical heterodyning in a second part of the switched mode power amplifier that is located in said at least one remote antenna head, and said electrical data signals are amplified in the second part of the switched mode power amplifier in a switched output stage.

Further developments of the invention can be gathered from the dependent claims and the following description.

In the following the invention will be explained further making reference to the attached drawings.

Fig. 1 schematically shows a cellular communication network with a base station and remote antenna heads in which the invention can be implemented.

Fig. 2 schematically shows a switched mode power amplifier architecture relying on a voltage switched circuit topology according to the state-of-the-art.

Fig. 3 schematically shows a delta sigma modulator according to the state-of-the-art.

Fig. 4 schematically shows a switched mode power amplifier with a delta sigma modulator, a switched output stage and a filter according to the state-of-the-art.

Fig. 5 schematically shows a switched mode power amplifier that is divided into two parts located in a base station and in a remote antenna head respectively according to the invention.

Fig. 6 schematically shows a transmitter and a receiver with a switched mode power amplifier that applies the concept of optical heterodyning according to the invention.

Fig. 7 schematically shows a switched mode power amplifier that applies the concept of optical heterodyning for several basebands with different baseband frequencies according to the invention.

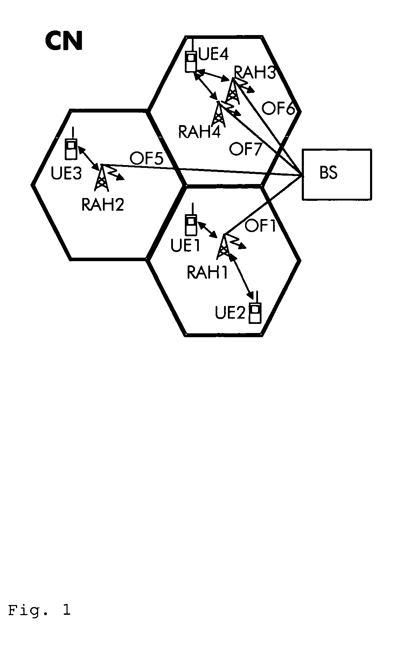

The principle structure of a communication network CN for signal transmission and reception in which the invention can be implemented is shown in fig. 1. The communication network CN comprises a base station BS, remote antenna heads RAH1-RAH4 and user terminals UE1-UE4.

Each of said remote antenna heads RAH1-RAH4 is connected to the base station BS by means of an optical connection, as e.g. an optical fiber or an optical free-space connection, OF1, OF2, OF3 and OF4 respectively. Each of said user terminals UE1-UE4 is connected to one or multiple of said remote antenna heads RAH1-RAH4, which is symbolized by double arrows in fig. 1. The base station BS is in turn connected to a core network, which is not shown in fig. 1 for the sake of simplicity.

For amplification of signals that shall be transmitted from the base station BS via a remote antenna head RAH1-RAH4 to a user terminal UE1-UE4, preferably switched mode power amplifiers are used that are preferably located in the remote antenna heads RAH1-RAH4.

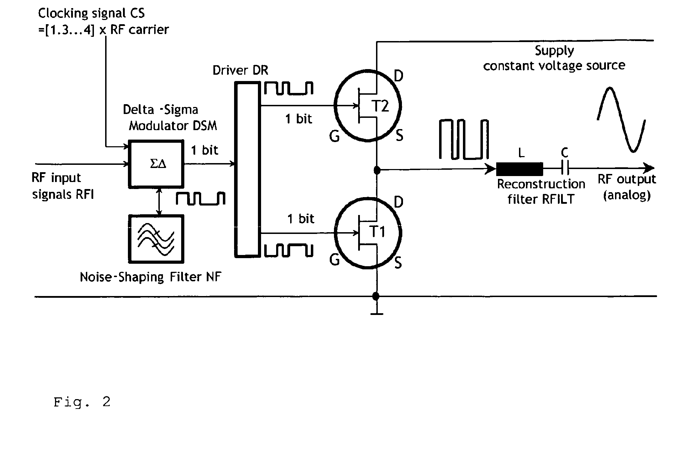

As an example for a switched mode power amplifier, a voltage switched power amplifier system according to the state-of-the-art is shown in fig. 2. Such a voltage switched power amplifier system comprises a delta-sigma modulator DSM with inputs for reception of an analogue radio frequency input signal RFI and for reception of a clocking signal CS. An output of the delta-sigma modulator DSM is connected to an input of a driver DR.

Preferably, the delta-sigma modulator DSM is connected to a noise-shaping filter NF or comprises a noise shaping filter.

A first output of the driver DR is connected to the gate G of a first transistor T1, and a second output of the driver DR is connected to the gate G of a second transistor T2.

The source S of the first transistor T1 is connected to ground, and the source of the second transistor T2 is connected to the drain of the first transistor T1.

The drain of the first transistor T1 and the source of the second transistor T2 are connected to a radio frequency output via a reconstruction filter RFILT that comprises an inductor L and a capacitor C in series. There are variants of the L-C filter topology which however are of no importance for the invention as disclosed.

The drain of the second transistor T2 is connected to the supply of a constant voltage source.

In a method for signal amplification using a voltage switched power amplifier system according to the state-of-the-art as shown in fig. 2, analogue radio frequency input signals are sent to the delta-sigma modulator DSM. Furthermore, clocking signals with a multiple of the radio frequency carrier frequency are sent to the delta-sigma modulator DSM.

In the delta-sigma modulator DSM, the analogue radio frequency input signals are converted into digital 1-bit or higher resolution signals. The sampling rate is determined by the received clocking signals. The digital 1-bit signals are provided at the output of the delta-sigma modulator DSM.

Preferably, the noise shaping filter NF is used to minimize quantization error by means of shifting quantization noise into frequency ranges that are less or not relevant for signal processing.

Said digital 1-bit signals are sent to the driver DR that generates first driver signals based on the digital 1-bit signals and second driver signals based on the inverted digital 1-bit signals. The first driver signals are sent to the gate of the second transistor T2, and the second driver signals are sent to the gate of the first transistor T1. The output signals of the driver DR are thus in antiphase which means if the first transistor T1 is on, the second transistor T2 is off and vice versa. The described amplifier architecture with two transistors T1, T2 is just an example, and in alternative architectures, more than two transistors are used, which has however no influence on the invention. Such alternative architectures are e.g. multibit architectures, using two transistors more per each bit more.

The capacitor C and the inductor L together build a reconstruction filter RFILT used to generate smooth analogue output signals that are provided at the radio frequency output.

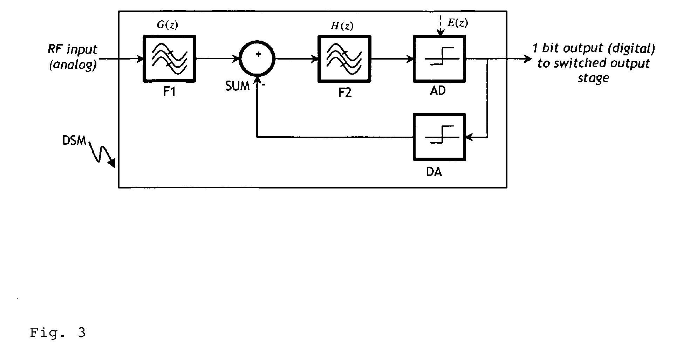

Fig. 3 is illustrating a delta sigma modulator DSM according to the state-of-the-art. The delta sigma modulator DSM comprises a filter F1, a summer SUM, a noise shaping filter F2, an analog-to-digital converter AD and a digital-to-analog converter DA.

The filter F1 has an input for receiving analogue input signals. The output of the filter F1 is connected to a first input of the summer SUM.

The output of the summer SUM is connected to the input of the noise shaping filter F2, and the output of the noise shaping filter F2 is connected to the input of the analog-to-digital converter AD.

The output of the analog-to-digital converter AD is on the one hand connected to the input of the digital-to-analog converter DA, and can on the other hand be connected to an external device, as e.g. the driver D of the switched output stage in fig. 2, for transmitting digital output signals.

The output of the digital-to-analog converter DA is connected to a second inverting input of the summer SUM.

In principle, an analogue radio frequency input signal is encoded in the delta sigma modulator DSM into a two level digital output sequence that is appropriate for driving a switched output stage of a switched mode amplifier.

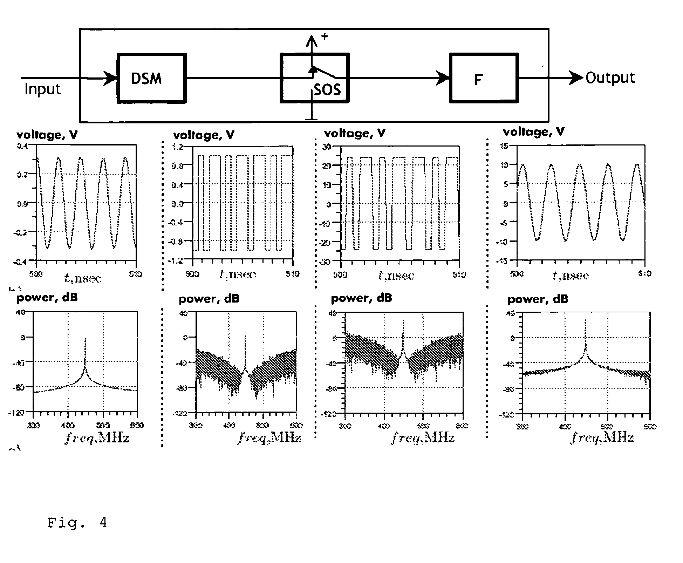

Fig. 4 is illustrating in the upper row schematically a switched mode power amplifier according to the state of the art that comprises a delta sigma modulator DSM as depicted in fig. 3, a switched output stage SOS, and a filter F. The switched output stage SOS comprises e.g. the driver DR and the two transistors T1 and T2 as depicted in fig. 2. However, as the described amplifier architecture with one driver DR and two transistors T1, T2 in fig. 2 is just an example, in alternative architectures, only one transistor or more than two transistors with more than one driver are used, i.e. the switched output stage SOS can comprise an arbitrary number of drivers and transistors, which has however no influence on the invention.

The delta sigma modulator DSM has an input for receiving input signals. The output of the delta sigma modulator DSM is connected to the input of the switched output stage SOS.

The output of the switched output stage SOS is connected to the input of the filter F, and the filter F comprises an output for transmitting output signals.

In the middle row, 4 diagrams are showing the signal voltage in volts versus time in nanoseconds from left to right for signals at the input of the delta sigma modulator DSM, at the output of the delta sigma modulator DSM, at the output of the switched output stage SOS, and at the output of the filter F.

In the lower row, 4 diagrams are showing the signal power density spectrum in decibels versus frequency in megahertz from left to right for signals at the input of the delta sigma modulator DSM, at the output of the delta sigma modulator DSM, at the output of the switched output stage SOS, and at the output of the filter F.

As can be seen from the first two diagrams in the middle row, the delta sigma modulator converts analogue signals into digital signals, and according to the invention, said digital signals will be transmitted over an optical fiber to the switched output stage SOS that is remotely located in a remote antenna head.

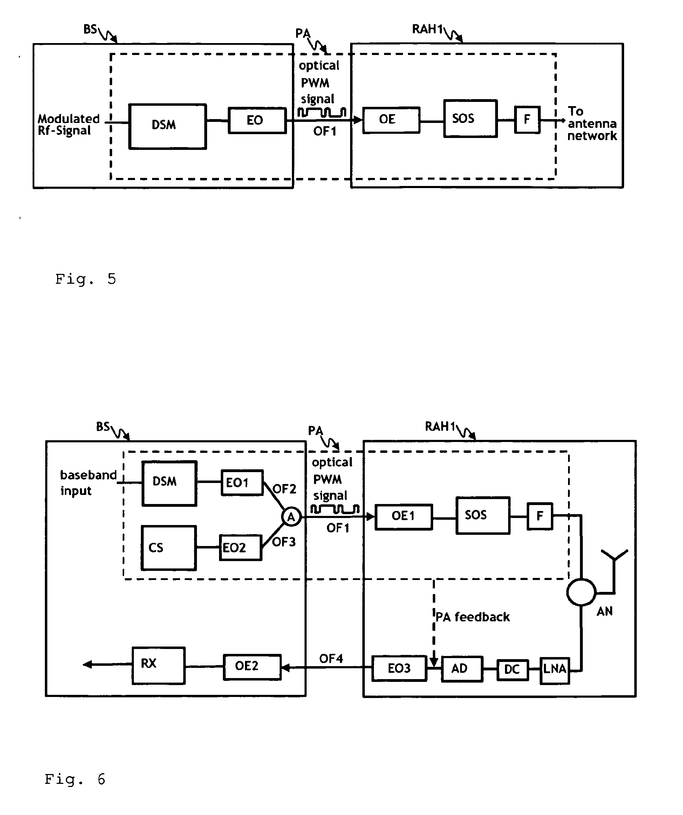

A switched mode power amplifier PA according to the invention is depicted in fig. 5. The switched mode power amplifier PA is indicated as a dashed box and comprises a delta sigma modulator DSM, an electro-optical converter EO, an opto-electrical converter OE, a switched output stage SOS and a filter F. The switched output stage in turn comprises at least one driver and at least one transistor as described above under fig. 4.

The delta sigma modulator DSM has an input for receiving analogue input signals. An output of the delta sigma modulator DSM is connected to an input of the electro-optical converter EO.

An output of the electro-optical converter EO is connected to an input of the opto-electrical converter OE through an optical connection OF1, as e.g. an optical fiber or an optical free-space connection.

An output of the opto-electrical converter OE is connected to an input of the switched output stage SOS, and an output of the switched output stage SOS is connected to an input of the filter F.

In an embodiment of the invention, a further device for signal conditioning, as e.g. an equalizer or a pre-amplifier, is comprised in the signal path between the electro-optical converter EO and the opto-electrical converter OE, or in the signal path between the opto-electrical converter OE and the switched output stage SOS.

An output of the filter F in turn is connected to an antenna network, which is not depicted in fig. 5 for the sake of simplicity.

In the embodiment depicted in fig. 5, the delta sigma modulator DSM and the electro-optical converter EO are comprised in a base station BS, which is indicated as a box, and the opto-electrical converter OE, the switched output stage SOS and the filter F are comprised in a remote antenna head RAH1, which is also indicated as a box.

In the delta sigma modulator DSM, analogue radio frequency signals that the delta sigma modulator DSM receives at its input are converted into digital signals. Said digital signals are sent to the electro-optical converter EO for converting the digital electrical signals into digital optical signals. Preferably, said electro-optical converter EO comprises a laser diode which is either directly modulated or externally modulated e.g. by means of a electroabsorption or lithiumniobate modulator.

From the output of the electro-optical converter EO, the digital optical signals, as e.g. PWM signals (PWM = Pulse Width Modulation), are sent over the optical connection OF1, as e.g. an optical fiber or an optical free-space connection, to an input of the opto-electrical converter OE.

In the opto-electrical converter OE, the digital optical signals are back-converted into digital electrical signals. Preferably, said opto-electrical converter OE comprises a so-called PIN-diode or a so-called avalanche-photo-diode. The digital electrical signals are sent from an output of the opto-electrical converter OE to an input of the switched output stage SOS.

In the switched output stage SOS, the digital electrical signals drive at least one transistor via at least one driver, which leads to amplified digital electrical signals at the output of the switched output stage SOS.

Said amplified digital electrical signals are sent to the input of the filter F, and by means of said filter F, the amplified analogue radio frequency signals are reconstructed and sent via the output of the filter F to the antenna network for transmission over an air interface.

A switched mode power amplifier PA applying the principle of optical heterodyning according to the invention is depicted in fig. 6. The switched mode power amplifier PA is indicated as a dashed box and comprises a delta sigma modulator DSM, a carrier synthesizer CS, two electro-optical converters EO1, E02, an adder A, an opto-electrical converter OE1, a switched output stage SOS and a filter F. The switched output stage in turn comprises at least one driver and at least one transistor as described above under fig. 4.

In the embodiment depicted in fig. 6, the delta sigma modulator DSM, the carrier synthesizer CS, the two electro-optical converters EO1, E02, and the adder A are comprised in a base station BS, which is indicated as a box, and the opto-electrical converter OE1, the switched output stage SOS and the filter F are comprised in a remote antenna head RAH1, which is also indicated as a box.

The base station BS further comprises a second opto-electrical converter OE2 and a receiver RX.

The remote antenna head RAH1 further comprises an antenna network AN, a low noise amplifier LNA, a down converter DC, an analogue to digital converter AD and a further electro-optical converter EO3.

The delta sigma modulator DSM has an input for receiving input signals. An output of the delta sigma modulator DSM is connected to an input of the first electro-optical converter EO1, and an output of the first electro-optical converter EO1 is connected to an input of the adder A through an optical fiber OF2.

An output of the carrier synthesizer CS is connected to an input of the second electro-optical converter E02, and an output of the second electro-optical converter E02 is connected to a further input of the adder A through an optical fiber OF3.

The output of the adder A is connected to an input of the opto-electrical converter OE1 through an optical connection OF1, as e.g. an optical fiber or an optical free-space connection.

An output of the opto-electrical converter OE1 is connected to an input of the switched output stage SOS, and an output of the switched output stage SOS is connected to an input of the filter F, and an output of the filter F is in turn connected to an antenna network AN.

In an embodiment of the invention, a further device for signal conditioning, as e.g. an equalizer or a pre-amplifier, is comprised in the signal paths between the electro-optical converters EO1 and E02 and the opto-electrical converter OE1, or in the signal path between the opto-electrical converter OE1 and the switched output stage SOS.

In a reception path, an output of the antenna network is connected to an input of the low noise amplifier LNA, and an output of the low noise amplifier LNA is connected to an input of the down converter DC.

An output of the down converter DC is connected to an input of the analogue to digital converter AD, and an output of the analogue to digital converter AD is connected to an input of the further electro-optical converter EO3.

An output of the further electro-optical converter EO3 is connected to an input of the second opto-electrical converter OE2 through an optical connection OF4 as e.g. an optical fiber or an optical free-space connection.

The output of the opto-electrical converter OE2 is in turn connected to an input of the receiver RX.

In an embodiment of the invention, an output of the switched mode power amplifier PA is connected to the reception path, preferably at an input of the further electro-optical converter EO3.

In the delta sigma modulator DSM, signals on a baseband frequency or on at least one intermediate frequency f_{if} preferably in the frequency range 10-100 MHz that the delta sigma modulator DSM receives at its input are converted into PWM signals (PWM = Pulse Width Modulation).

In the following, the invention is described for signals on an intermediate frequency f_{if}, however, the invention is also working for signals on a baseband frequency in an analogue manner.

After conversion, the digital signals are sent to the electro-optical converter EO1 for converting the digital electrical signals into digital optical signals using an optical source with f_{optical} being the frequency of the light of the optical source, so that the digital optical signals have a frequency fₒₛ= f_{optical}± f_{if}.

From the output of the electro-optical converter EO1, the digital optical signals, as e.g. PWM signals (PWM = Pulse Width Modulation), are sent over the optical fiber OF2 to the input of the adder A.

In the carrier synthesizer CS, radio frequency carrier signals on a radio frequency f_{rf} preferably in the frequency range of several hundreds of MHz to several GHz are generated. The radio frequency carrier signals are sent to the electro-optical converter E02 for converting the electrical radio frequency carrier signals into optical radio frequency carrier signals using an optical source with f_{optical} being the frequency of the light of the optical source, so that the optical radio frequency carrier signals have a frequency f_{orf}= f_{optical}± f_{rf}.

From the output of the electro-optical converter E02, the optical radio frequency carrier signals are sent over the optical fiber OF3 to the further input of the adder A.

Preferably, said electro-optical converters EO1 and E02 comprise a laser diode which is either directly modulated, or external modulation of light, e.g. by means of an electroabsorption or lithiumniobate modulator is applied.

In the adder A, , the digital optical signals are added with the optical radio frequency carrier signals, i.e. the digital optical signals with the frequency fₒₛ= f_{optical}± f_{if} are summed up with the optical radio frequency carrier signals with the frequency f_{orf}= f_{optical}± f_{rf}, which results in combined optical data signals.

From the output of the adder A, the combined optical data signals, as e.g. PWM signals (PWM = Pulse Width Modulation), are sent over the optical connection OF1 to an input of the opto-electrical converter OE1.

In the opto-electrical converter OE1, the principle of optical heterodyning is applied, and the digital optical signals are upconverted into digital electrical signals. The intensity of the detected electrical signals varies with a frequency f_{des}=f_{rf}±f_{if}, as all higher frequency components of the intensity in the range of f_{optical} are time averaged in the opto-electrical converter OE1. Preferably, said opto-electrical converter OE comprises a so-called PIN-diode or a so-called avalanche-photo-diode. The digital electrical signals are sent from an output of the opto-electrical converter OE to an input of the switched output stage SOS.

In the switched output stage SOS, the digital electrical signals drive at least one transistor via at least one driver, which leads to amplified digital electrical signals at the output of the switched output stage SOS.

Said amplified digital electrical signals are sent to the input of the filter F, and by means of said filter F, the amplified analogue radio frequency signals are reconstructed and sent via the output of the filter F to the antenna network AN for transmission over an air interface.

In the reception path, analogue electrical signals are sent from the antenna network AN to the low noise amplifier LNA for signal amplification.

The amplified analogue electrical signals are sent to the down converter DC in which the signals are downconverted from the radio frequency to the intermediate frequency.

The downconverted analogue electrical signals are sent to the analogue to digital converter AD for digitalization, and the digital electrical signals are sent to the further electro-optical converter EO3 for converting the digital electrical signals into digital optical signals.

The digital optical signals are sent from the further electro-optical converter EO3 to the second opto-electrical converter OE2 through the optical connection OF4.

In the second opto-electrical converter OE2, the digital optical signals are back-converted into digital electrical signals and sent to the receiver RX for further processing.

In an embodiment of the invention, if linearization of the power amplifier PA should become necessary, an output signal of the power amplifier PA is fed back via the further electro-optical converter EO3 and the optical connection OF4 to the base station BS, and based on said fed back output signal, the power amplifier PA is controlled.

Advantages of the above described embodiment of the invention are, that by using optical heterodyning, the need for electrical upconversion is dropped, and the delta sigma conversion related signal processing is performed on baseband level at considerably reduced speed and hence reduced power dissipation and chip complexity.

In an embodiment of the invention, the transmission path described above is extended by introduction of a multi carrier synthesizer centered at the intermediate frequency f_{if}, followed by a wideband capable delta sigma modulator as well as a wideband capable switched output stage followed by a suitable reconstruction filter on the remote antenna side.

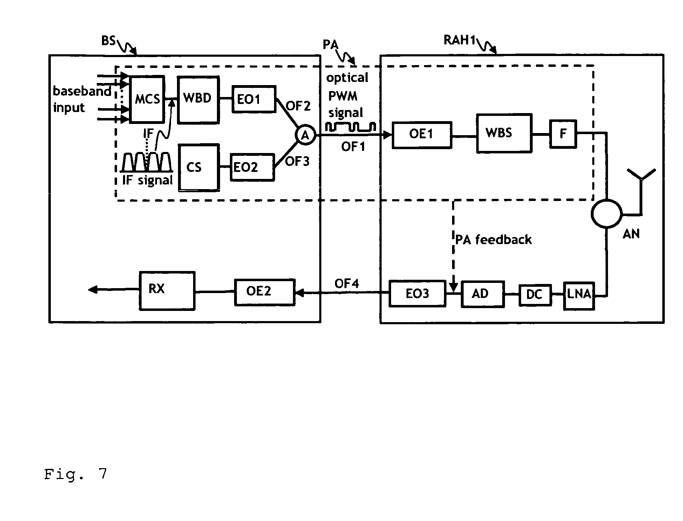

A switched mode power amplifier PA applying the principle of optical heterodyning according to the invention for multiple carriers is depicted in fig. 7. The principle structure is similar to the one depicted in fig. 6, so that only the differences are described.

The delta sigma modulator DSM from fig. 6 is replaced in fig. 7 by a synthesizer MCS and a delta sigma modulator WBD that is appropriate for wideband modulation. Furthermore, the switched output stage SOS from fig. 6 is replaced in fig. 7 by a wideband switched output stage WBS.

The synthesizer MCS has at least two inputs for receiving data signals related to at least two basebands with different baseband frequencies.

The synthesizer MCS is connected to the delta sigma modulator WBD that is appropriate for wideband modulation, and the delta sigma modulator WBD is in turn connected to the electro-optical converter EO1.

Assumed that the synthesizer MCS has n inputs, a number n of modulated baseband signals with bandwidth Δν that are shifted by a certain channel spacing of e.g. i*Δν with i= -n/2 ...n/2, i ≠0 are sent each to a different input of the synthesizer MCS. The modulated baseband signals are added onto an intermediate frequency carrier and forwarded to the delta sigma modulator WBD.

The resulting pulse width modulation stream is converted to optical domain and transmitted to the remote antenna site RAH1 as described above under fig. 6. After back-conversion to electrical domain the pulse stream drives the wideband switched output stage WBS.

This embodiment of the invention allows for transmission of several wideband signals with a total bandwidth of several hundreds of MHz by means of an optically controlled single wideband power amplifier.

In a further embodiment of the invention, signals from the base station BS are transmitted through at least two optical connections OF6, OF7 via at least two remote antenna heads RAH3, RAH4 to a user terminal UE4 applying so-called beamforming or multiple-input-multiple-output, as depicted in fig. 1 for the case of two remote antenna heads RAH3 and RAH4 that are used for signal transmission to the user terminal UE4.

Such a switched mode power amplifier PA according to the invention can be used e.g. for a communication network applying the standard Universal Mobile Telecommunications System, Third Generation Partnership Project Long Term Evolution, or Worldwide Interoperability for Microwave Access.

In the embodiments described above, the opto-electrical converter OE or OE1, and the switched output stage SOS or WBS are depicted as two distinct devices. However, in further embodiments of the invention, the opto-electrical converter OE or OE1, and the switched output stage SOS or WBS can also be colocated, i.e. they are two parts of one device. An example for such colocated devices is the vertical integration of an avalanche-photo-diode with a high electron mobility transistor (HEMT). In this example, the opto-electrical converter OE or OE1 is realized as an avalanche-photo-diode, and the switched output stage SOS or WBS is realized as a high electron mobility transistor (HEMT).

In the embodiments above, the invention is described for the transmission of signals from a base station BS via at least one remote antenna head RAH1 to a user terminal UE1, however the invention is also applicable for transmission of signals from an arbitrary transmitting device to an arbitrary receiving device, as e.g. used in a point-to-point radio system or used for connection of devices within a rack.

## Claims

1. A method for transmission of data signals from a transmitting device (BS) to at least one receiving device (RAH1) using a switched mode power amplifier (PA) for signal amplification, wherein said data signals are transmitted over at least one optical connection (OF1) from the transmitting device (BS) to the at least one receiving device (RAH1) wherein
• data signals are modulated in a delta sigma modulator (DSM) comprised in a first part of the switched mode power amplifier (PA) that is located in the transmitting device (BS) resulting in modulated data signals,
• the modulated data signals are converted from electrical signals into optical data signals in an electro-optical converter (EO1) in the first part of the switched mode power amplifier (PA),
**characterized in, that**
• radio frequency carrier signals are converted from electrical signals into optical radio frequency carrier signals in a further electro-optical converter (EO2) in the first part of the switched mode power amplifier (PA),
• the optical data signals are added with the optical radio frequency carrier signals resulting in combined optical data signals,
• the combined optical data signals are upconverted from optical data signals resulting in upconverted electrical data signals applying optical heterodyning in an opto-electrical converter (OE1) in a second part of the switched mode power amplifier (PA) that is located in said at least one receiving device (RAH1),
• and said upconverted electrical data signals are amplified in the second part of the switched mode power amplifier (PA) in a switched output stage (SOS).

2. A method according to claim 1, **characterized in, that** said transmitting device (BS) is a base station (BS) and said at least one receiving device (RAH1) is a remote antenna head (RAH1), and said signals are transmitted from the base station (BS) via the at least one remote antenna head (RAH1) to a user terminal (UE1).

3. A method according to claim 2, **characterized in, that** signals from the base station (BS) are transmitted via at least two remote antenna heads (RAH3, RAH4) to a user terminal (UE4) applying beamforming or multiple-input-multiple-output.

4. A method according to claim 1, **characterized in, that** said signals are conditioned in a device for signal conditioning in the signal path between the electro-optical converters (EO1, E02) and the switched output stage (SOS).

5. A method according to claim 1, **characterized in, that**
• said data signals are modulated baseband signals which are shifted in frequency,
• said data signals shifted in frequency are modulated on an intermediate frequency carrier in a synthesizer (MCS),
• and said data signals are modulated in a delta sigma modulator (WBD) that is appropriate to carry out wide-band modulation.

6. A method according to claim 1, **characterized in, that**
• an output signal of the power amplifier (PA) is fed back via an electro-optical converter (EO3) and an optical connection (OF4) to the base station (BS),
• and based on said fed back output signal, the power amplifier (PA) is controlled.

7. A switched mode power amplifier (PA) **characterized in, that**
• a first part of the switched mode power amplifier (PA) comprises a delta sigma modulator (DSM) that is adapted to modulate data signals and that is connected to an adder (A) via a first electro-optical converter (EO1),
• said first part of the switched mode power amplifier (PA) further comprises a carrier synthesizer (CS) that is adapted to create radio frequency carrier signals and that is connected to said adder (A) via a second electro-optical converter (EO2),
• said adder (A) is adapted to combine optical signals,
• a second part of the switched mode power amplifier (PA) comprises an opto-electrical converter (OE1) and a switched output stage (SOS),
• said opto-electrical converter (OE1) is adapted to upconvert said optical signals applying optical heterodyning,
• and said first and second part of the switched mode power amplifier (PA) are connected through an optical connection (OF1).

8. A switched mode power amplifier (PA) according to claim 7, **characterized in, that** the switched mode power amplifier (PA) comprises a class D, E or F switched output stage (SOS).

9. A communication network (CN) comprising a switched mode amplifier (PA) according to claim 7 for transmission of signals from a base station (BS) via a remote antenna head (RAH1) to a user terminal (UE1).

## Patentansprüche

1. Verfahren zur Übertragung von Datensignalen von einer Sendevorrichtung (ES) an mindestens eine Empfangsvorrichtung (RAH1) unter Verwendung eines Schaltmodus-Leistungsverstärkers (PA) zur Signalverstärkung, wobei die besagten Datensignale über mindestens eine optische Verbindung (OF1) von der Sendevorrichtung (BS) an die mindestens eine Empfangsvorrichtung (RAH1) übertragen werden, wobei
• Datensignale in einem in einem ersten Teil des Schaltmodus-Leistungsverstärkers (PA), welcher in der Sendevorrichtung (BS) angeordnet ist, umfassten Delta-Sigma-Modulator (DSM) moduliert werden, wodurch modulierte Datensignale entstehen,
• die modulierten Datensignale in einem elektro-optischen Konverter (EO1) im ersten Teil des Schaltmodus-Leistungsverstärkers (PA) von elektrischen Signalen in optische Datensignale konvertiert werden,
**dadurch gekennzeichnet, dass**
• Funkfrequenzträgersignale in einem weiteren elektro-optischen Konverter (EO2) in dem ersten Teil des Schaltmodus-Leistungsverstärkers (PA) von elektrischen Signalen in optische Funkfrequenzträgersignale konvertiert werden,
• die optischen Datensignale mit den optischen Funkfrequenzträgersignalen addiert werden, wodurch kombinierte optische Datensignale entstehen,
• die kombinierten optischen Datensignale unter Anwendung einer optischen Überlagerung in einem opto-elektrischen Konverter (OE1) in einem zweiten Teil des Schaltmodus-Leistungsverstärkers (PA), welcher in der besagten mindestens einen Empfangsvorrichtung (RAH1) angeordnet ist, von optischen Datensignalen aufwärtskonvertiert werden, wodurch aufwärtskonvertierte elektrische Datensignale entstehen,
• und die besagten aufwärtskonvertierten elektrischen Datensignale in dem zweiten Teil des Schaltmodus-Leistungsverstärkers (PA) in einer geschalteten Ausgangsstufe (SOS) verstärkt werden.

2. Verfahren nach Anspruch 1, **dadurch gekennzeichnet, dass** die besagte Sendevorrichtung (BS) eine Basisstation (BS) und die besagte mindestens eine Empfangsvorrichtung (RAH1) ein entfernter Antennenkopf (RAH1) ist, und dass die besagten Signale über den besagten mindestens einen entfernten Antennenkopf (RAH1) von der Basisstation (BS) an ein Benutzerendgerät (UE1) übertragen werden.

3. Verfahren nach Anspruch 2, **dadurch gekennzeichnet, dass** Signale von der Basisstation (BS) über mindestens zwei entfernte Antennenköpfe (RAH3, RAH4) unter Verwendung von Beamforming oder Multiple-Input Multiple-Output an ein Benutzerendgerät (UE4) übertragen werden.

4. Verfahren nach Anspruch 1, **dadurch gekennzeichnet, dass** die besagten Signale in einer Vorrichtung zur Signalkonditionierung in dem Signalpfad zwischen den elektro-optischen Konverter (EO1, EO2) und der geschalteten Ausgangsstufe (SOS) konditioniert werden.

5. Verfahren nach Anspruch 1, **dadurch gekennzeichnet, dass**
• die besagten Datensignale modulierte Basisbandsignale sind, welche frequenzversetzt sind,
• die besagten frequenzversetzten Datensignal auf einem Zwischenfrequenzträger in einem Synthesizer (MCS) modulierte werden,
• und die besagten Datensignale in einem Delta-Sigma-Modulator (WBD), welcher für das Durchführen einer Breitbandmodulation geeignet ist, moduliert werden.

6. Verfahren nach Anspruch 1, **dadurch gekennzeichnet, dass**
• ein Ausgangssignal des Leistungsverstärkers (PA) über einen elektro-optischen Konverter (EO3) und eine optische Verbindung (OF4) an die Basisstation (BS) rückgekoppelt wird,
• und der Leistungsverstärker (PA) auf der Basis des besagten rückgekoppelten Ausgangssignals gesteuert wird.

7. Schaltmodus-Leistungsverstärker (PA), **dadurch gekennzeichnet, dass**
• ein erster Teil des Schaltmodus-Leistungsverstärkers (PA) einen Delta-Sigma-Modulator (DSM) umfasst, welcher für das Modulierten von Datensignalen ausgelegt und über einen ersten elektro-optischen Konverter (EO1) an einen Addierer (A) angeschlossen ist,
• ein erster Teil des Schaltmodus-Leistungsverstärkers (PA) weiterhin einen Träger-Synthesizer (CS) umfasst, welcher für das Erzeugen von Funkfrequenzträgersignalen ausgelegt und über einen zweiten elektro-optischen Konverter (E02) an den besagten Addierer (A) angeschlossen ist,
• der besagte Addierer (A) für das Kombinieren von optischen Signalen ausgelegt ist,
• ein zweiter Teil des Schaltmodus-Leistungsverstärkers (PA) einen opto-elektrischen Konverter (OE1) und eine geschaltete Ausgangsstufe (SOS) umfasst,
• der besagte opto-elektrische Konverter (OE1) für das Aufwärtskonvertieren der besagten optischen Signale unter Anwendung einer optischen Überlagerung ausgelegt ist,
• und der besagte erste und der besagte zweite Teil des Schaltmodus-Leistungsverstärkers (PA) über eine optische Verbindung (OF1) angeschlossen sind.

8. Schaltmodus-Leistungsverstärker (PA) nach Anspruch 7, **dadurch gekennzeichnet, dass** der Schaltmodus-Leistungsverstärker (PA) eine geschaltete Ausgangsstufe (SOS) der Klasse D, E oder F umfasst.

9. Kommunikationsnetzwerk (CN) mit einem Schaltmodus-Verstärker (PA) nach Anspruch 7 zur Übertragung von Signalen von einer Basisstation (ES) über einen entfernten Antennenkopf (RAH1) an ein Benutzerendgerät (UE1).

## Revendications

1. Procédé de transmission de signaux de données depuis un dispositif d'émission (BS) vers au moins un dispositif de réception (RAH1) en utilisant un amplificateur de puissance en mode commuté (PA) pour l'amplification de signal, dans lequel lesdits signaux de données sont transmis sur au moins une connexion optique (OF1) depuis le dispositif d'émission (BS) vers l'au moins un dispositif de réception (RAH1) dans lequel
• des signaux de données sont modulés dans un modulateur delta-sigma (DSM) contenu dans une première partie de l'amplificateur de puissance en mode commuté (PA) qui est situé dans le dispositif d'émission (BS) produisant des signaux de données modulés,
• les signaux de données modulés sont des signaux électriques convertis en signaux de données optiques dans un convertisseur électro-optique (EO1) dans la première partie de l'amplificateur de puissance en mode commuté (PA),
**caractérisé en ce que**
• des signaux porteurs de radiofréquence sont des signaux électriques convertis en signaux porteurs de radiofréquence optiques dans un autre convertisseur électro-optique (EO2) dans la première partie de l'amplificateur de puissance en mode commuté (PA),
• les signaux de données optiques sont ajoutés aux signaux porteurs de radiofréquence optiques produisant des signaux de données optiques combinés,
• les signaux de données optiques combinés subissent une montée en fréquence à partir de signaux de données optiques produisant des signaux de données électriques ayant subi une montée en fréquence en appliquant un hétérodynage optique dans un convertisseur opto-électrique (OE1) dans une deuxième partie de l'amplificateur de puissance en mode commuté (PA) qui est situé dans ledit au moins un dispositif de réception (RAH1),
• et lesdits signaux de données électriques ayant subi une montée en fréquence sont amplifiés dans la deuxième partie de l'amplificateur de puissance en mode commuté (PA) dans un étage de sortie commuté (SOS).

2. Procédé selon la revendication 1, **caractérisé en ce que** ledit dispositif d'émission (BS) est une station de base (BS) et ledit au moins un dispositif de réception (RAH1) est une tête d'antenne distante (RAH1), et lesdits signaux sont transmis de la station de base (BS) à un terminal utilisateur (UE1) par l'intermédiaire de l'au moins une tête d'antenne distante (RAH1).

3. Procédé selon la revendication 2, **caractérisé en ce que** des signaux provenant de la station de base (BS) sont transmis à un terminal utilisateur (UE4) par l'intermédiaire d'au moins deux têtes d'antenne distantes (RAH3, RAH4) en appliquant la formation de faisceau ou l'entrée multiple - sortie multiple.

4. Procédé selon la revendication 1, **caractérisé en ce que** lesdits signaux sont conditionnés dans un dispositif pour le conditionnement de signaux dans le chemin de signal entre les convertisseurs électro-optiques (EO1, EO2) et l'étage de sortie commuté (SOS).

5. Procédé selon la revendication 1, **caractérisé en ce que**
• lesdits signaux de données sont des signaux en bande de base modulés qui sont décalés en fréquence,
• lesdits signaux de données décalés en fréquence sont modulés sur une porteuse de fréquence intermédiaire dans un synthétiseur (MCS),
• et lesdits signaux de données sont modulés dans un modulateur delta-sigma (WBD) qui est adapté pour exécuter une modulation à large bande.

6. Procédé selon la revendication 1, **caractérisé en ce que**
• un signal de sortie de l'amplificateur de puissance (PA) est renvoyé par l'intermédiaire d'un convertisseur électro-optique (EO3) et d'une connexion optique (OF4) à la station de base (BS),
• et, sur la base dudit signal de sortie renvoyé, l'amplificateur de puissance (PA) est commandé.

7. Amplificateur de puissance en mode commuté (PA) **caractérisé en ce que**
• une première partie de l'amplificateur de puissance en mode commuté (PA) comprend un modulateur delta-sigma (DSM) qui est adapté pour moduler des signaux de données et qui est connecté à un additionneur (A) par l'intermédiaire d'un premier convertisseur électro-optique (EO1),
• ladite première partie de l'amplificateur de puissance en mode commuté (PA) comprend en outre un synthétiseur de porteuse (CS) qui est adapté pour créer des signaux porteurs de radiofréquence et qui est connecté audit additionneur (A) par l'intermédiaire d'un deuxième convertisseur électro-optique (EO2),
• ledit additionneur (A) est adapté pour combiner des signaux optiques,
• une deuxième partie de l'amplificateur de puissance en mode commuté (PA) comprend un convertisseur opto-électrique (OE1) et un étage de sortie commuté (SOS),
• ledit convertisseur opto-électrique (OE1) est adapté pour appliquer une montée en fréquence auxdits signaux optiques en appliquant un hétérodynage optique,
• et lesdites première et deuxième parties de l'amplificateur de puissance en mode commuté (PA) sont connectées par l'intermédiaire d'une connexion optique (OF1).

8. Amplificateur de puissance en mode commuté (PA) selon la revendication 7, **caractérisé en ce que** l'amplificateur de puissance en mode commuté (PA) comprend un étage de sortie commuté (SOS) de classe D, E ou F.

9. Réseau de communication (CN) comprenant un amplificateur en mode commuté (PA) selon la revendication 7 pour la transmission de signaux depuis une station de base (BS) à un terminal utilisateur (UE1) par l'intermédiaire d'une tête d'antenne distante (RAH1).
